# EUROPEAN PATENT APPLICATION

(11) **EP 4 576 996 A1**
(43) Date of publication of application: **25.06.2025**
(21) Application number: 24210748.0
(22) Date of filing: 05.11.2024
(51) Int. Cl.: H10D 84/01, H10D 84/83, G03F 7/00

(54) **EXTREME ULTRAVIOLET (EUV) GATE PATTERNING OF VARYING GATE LENGTHS**

(30) Priority: 18.12.2023 US 202318543428
(71) Applicant: Intel Corporation, Santa Clara, CA 95054 (US)
(72) Inventor: Guillaume, Bouche, Portland, 97211 (US); Sacks, George J., Ridgefield, 98642 (US); Jun, Hwichan, Portland, 97229 (US)
(74) Representative: Goddar, Heinz J.

(57) **Abstract**

Techniques are provided herein to form semiconductor devices having different gate lengths yet maintaining a substantially similar pitch between gates. A row of semiconductor devices having semiconductor regions extending in a first direction can include some devices having a first gate length in the first direction and some devices having a second gate length in the first direction, where the second gate length is greater from the first gate length (e.g., by 2 nm or more). According to some embodiments, a given gate structure that extends in a second direction substantially orthogonal to the first direction can have its gate length transition between the first gate length and the second gate length at a region between adjacent semiconductor regions along the second direction. When observed in a plan view, the second gate length extends beyond both sides of the first gate length along the first direction.

## Description

### BACKGROUND

As integrated circuits continue to scale downward in size, a number of challenges arise. For instance, reducing the size of memory and logic cells is becoming increasingly more difficult. Technology limitations in the lithography space can make it difficult to change particular transistor elements within a large array. Forming some semiconductor devices differently than others (e.g., with differing dimensions of certain features) often requires many additional fabrication steps. Accordingly, there remain a number of non-trivial challenges with respect to forming large arrays of semiconductor devices.

### BRIEF DESCRIPTION OF THE DRAWINGS

Figure 1A is a plan view of an integrated circuit including semiconductor devices with different gate lengths.
Figure 1B is a plan view of an integrated circuit including semiconductor devices with different gate lengths, in accordance with some embodiments of the present disclosure.
Figures 2A - 2E are plan views, that illustrate various stages in an example process for forming an integrated circuit configured with semiconductor devices with different gate lengths, in accordance with an embodiment of the present disclosure.
Figure 3 illustrates a cross-section view of a chip package containing one or more semiconductor dies, in accordance with some embodiments of the present disclosure.
Figure 4 is a flowchart of a fabrication process for semiconductor devices having different gate lengths, in accordance with an embodiment of the present disclosure.
Figure 5 illustrates a computing system including one or more integrated circuits, as variously described herein, in accordance with an embodiment of the present disclosure.

Although the following Detailed Description will proceed with reference being made to illustrative embodiments, many alternatives, modifications, and variations thereof will be apparent in light of this disclosure. As will be further appreciated, the figures are not necessarily drawn to scale or intended to limit the present disclosure to the specific configurations shown. For instance, while some figures generally indicate perfectly straight lines, right angles, and smooth surfaces, an actual implementation of an integrated circuit structure may have less than perfect straight lines, right angles (e.g., some features may have tapered sidewalls and/or rounded corners), and some features may have surface topology or otherwise be non-smooth, given real world limitations of the processing equipment and techniques used.

### DETAILED DESCRIPTION

Techniques are provided herein to form semiconductor devices having different gate lengths, yet maintaining a substantially similar pitch between gates. The techniques can be used in any number of integrated circuit applications and are particularly useful with respect to logic and memory cells, such as those cells that use finFETs, gate-all-around transistors, or forksheet transistors. In an example, a row of semiconductor devices having semiconductor regions (channel regions) extending in a first direction can include some devices having a first gate length (e.g., the length of the semiconductor regions having a gate structure around them) in the first direction and some devices having a second gate length in the first direction, where the second gate length is greater from the first gate length (e.g., by 3nm or less). According to some embodiments, a given gate structure that extends in a second direction substantially orthogonal to the first direction can have its gate length (measured along the first direction) change along its length. The gate length may transition between the first gate length and the second gate length at a region between adjacent semiconductor regions along the second direction. When observed in a plan view, the second gate length may extend beyond both sides of the first gate length along the first direction. As further described below, an extreme ultraviolet (EUV) process may be used to directly pattern the shape of the gate having the varying gate lengths in an array of gate structures having a pitch of, for instance, less than 80 nm in some example cases, or less than 36 nm in some other example cases. Numerous variations and embodiments will be apparent in light of this disclosure.

### General Overview

As previously noted above, there remain a number of non-trivial challenges with respect to forming a large array of semiconductor devices. For example, using devices with different gate lengths can be beneficial for applications that combine transistors used for different purposes (such as logic devices with memory devices). One possible solution is to scale-up certain gate structures to increase their gate length compared to other gate structures, but such a process may involve the use of multiple additional fabrication steps which increases the complexity and cost of the overall chip fabrication process. Moreover, such a process may introduce asymmetry into a given gate line structure, which in turn modifies the gate pitch, which can further exacerbate the complexity and cost issues.

Thus, and in accordance with an embodiment of the present disclosure, techniques are provided herein to form semiconductor devices having gate structures with varying gate lengths, while maintaining the gate pitch between adjacent gates. The pitch may be determined relative to a first direction along the length of the semiconductor regions (e.g., nanoribbons or fins) of the semiconductor devices. The gate structures extend over the semiconductor regions of one or more semiconductor devices in a second direction different from the first direction (e.g., orthogonal to the first direction). In some embodiments, a given gate structure may have its gate length transition between a first gate length and second gate length measured along the first direction. The same gate structure may also have its gate length transition back from the second gate length to the first gate length. The one or more transition regions between the first gate length and second gate length may be located between adjacent semiconductor regions along the second direction. According to some embodiments, the gate structure increases in length on both sides when transitioning from the first gate length to the second gate length. The second gate length may be, for example, at least 0.5 nm (such as between 0.5 nm and 3 nm) greater than the first gate length.

According to some embodiments, an EUV patterning process is used to create the plan-view shape of the gate structures. EUV lithography allows for a single mask to be used to pattern the change in gate length amongst gates having a relatively small pitch, such as a pitch of less than 80 nm in some example cases, or less than 51 nm in still other example cases. Additionally, the patterning process can create gradual transitions between the different gate lengths (e.g., a sloped or tapered transition as opposed to a more abrupt step transition, as detectable in a plan view).

According to an embodiment, an integrated circuit includes a first semiconductor region extending from a first source or drain region along a first direction, a second semiconductor region extending from a second source or drain region along the first direction, and a gate structure extending over the first semiconductor region and the second semiconductor region along a second direction different from the first direction. The gate structure has a first gate portion with a first gate length along the first direction over the first semiconductor region and a second gate portion with a second gate length along the first direction over the second semiconductor region. The second gate length is between 0.5-5 nm (e.g., 0.5-3 nm or 0.5-2 nm) greater than the first gate length. The second gate portion extends beyond both sides of the first gate portion along the first direction.

According to another embodiment, an electronic device includes a chip package having one or more dies. At least one of the one or more dies includes a first semiconductor region extending from a first source or drain region along a first direction, a second semiconductor region extending from a second source or drain region along the first direction, and a gate structure extending over the first semiconductor region and the second semiconductor region along a second direction different from the first direction. The gate structure has a first gate portion with a first gate length along the first direction over the first semiconductor region and a second gate portion with a second gate length along the first direction over the second semiconductor region. The second gate length is between 0.5-5 nm (e.g., 0.5-3 nm or 0.5-2 nm) greater than the first gate length. The second gate portion extends beyond both sides of the first gate portion along the first direction.

According to another embodiment, a method of forming an integrated circuit includes forming a first fin and a second fin comprising semiconductor material, the first and second fins extending above a substrate and extending parallel to each other in a first direction; forming sacrificial gate material over the first fin and the second fin; forming a dielectric cap material over the sacrificial gate material; patterning the sacrificial gate material and dielectric cap material to form a sacrificial gate strip extending in a second direction over the first fin and the second fin, wherein the sacrificial gate strip has a first portion with a first length along the first direction over the first fin and a second portion with a second length along the first direction over the second fin, the second length being between 0.5-5 nm (e.g., 0.5-3 nm or 0.5-2) nm greater than the first length, and wherein the second portion extends beyond both sides of the first portion along the first direction; forming spacer structures on sidewalls of the sacrificial gate strip; forming source or drain regions at ends of the first fin and second fin; and replacing the sacrificial gate strip with a gate structure.

The techniques can be used with any type of planar or non-planar transistors, including finFETs (sometimes called double-gate transistors, or tri-gate transistors), or nanowire, nanosheet, and nanoribbon transistors (sometimes called gate-all-around transistors), to name a few examples. The source and drain regions can be, for example, doped portions of a given fin or substrate, or epitaxial regions that are deposited during an etch-and-replace source/drain forming process. The dopant-type in the source and drain regions will depend on the polarity of the corresponding transistor. The source and drain regions may be any epitaxial diffusion region. The gate structure can be implemented with a gate-first process or a gate-last process (sometimes called a removal metal gate, or RMG, process). Any number of semiconductor materials can be used in forming the transistors, such as group IV materials (e.g., silicon, germanium, silicon germanium) or group III-V materials (e.g., gallium arsenide, indium gallium arsenide).

Use of the techniques and structures provided herein may be detectable using tools such as electron microscopy including scanning/transmission electron microscopy (SEM/TEM), scanning transmission electron microscopy (STEM), nano-beam electron diffraction (NBD or NBED), and reflection electron microscopy (REM); composition mapping; x-ray crystallography or diffraction (XRD); energy-dispersive x-ray spectroscopy (EDX); secondary ion mass spectrometry (SIMS); time-of-flight SIMS (ToF-SIMS); atom probe imaging or tomography; local electrode atom probe (LEAP) techniques; 3D tomography; or high resolution physical or chemical analysis, to name a few suitable example analytical tools. For instance, in some example embodiments, such tools may indicate the presence of one or more gate structures that have a varying gate length. The gate length may transition between a first length and a longer second length with the second length extending past both sides of the portion of the gate structure having the first gate length, and then possibly back to the first length. Numerous configurations and variations will be apparent in light of this disclosure.

It should be readily understood that the meaning of "above" and "over" in the present disclosure should be interpreted in the broadest manner such that "above" and "over" not only mean "directly on" something but also include the meaning of over something with an intermediate feature or a layer therebetween. Further, spatially relative terms, such as "beneath," "below," "lower," "above," "upper," "top," "bottom," and the like, may be used herein for ease of description to describe one element or feature's relationship to another element (s) or feature (s) as illustrated in the figures. The spatially relative terms are intended to encompass different orientations of the device in use or operation in addition to the orientation depicted in the figures. The apparatus may be otherwise oriented (rotated 90 degrees or at other orientations) and the spatially relative descriptors used herein may likewise be interpreted accordingly.

As used herein, the term "layer" refers to a material portion including a region with a thickness. A monolayer is a layer that consists of a single layer of atoms of a given material. A layer can extend over the entirety of an underlying or overlying structure, or may have an extent less than the extent of an underlying or overlying structure. Further, a layer can be a region of a homogeneous or inhomogeneous continuous structure, with the layer having a thickness less than the thickness of the continuous structure. For example, a layer can be located between any pair of horizontal planes between, or at, a top surface and a bottom surface of the continuous structure. A layer can extend horizontally, vertically, and/or along a tapered surface. A layer can be conformal to a given surface (whether flat or curvilinear) with a relatively uniform thickness across the entire layer.

Materials that are "compositionally different" or "compositionally distinct" as used herein refers to two materials that have different chemical compositions. This compositional difference may be, for instance, by virtue of an element that is in one material but not the other (e.g., SiGe is compositionally different than silicon), or by way of one material having all the same elements as a second material but at least one of those elements is intentionally provided at a different concentration in one material relative to the other material (e.g., SiGe having 70 atomic percent germanium is compositionally different than from SiGe having 25 atomic percent germanium). In addition to such chemical composition diversity, the materials may also have distinct dopants (e.g., gallium and magnesium) or the same dopants but at differing concentrations. In still other embodiments, compositionally distinct materials may further refer to two materials that have different crystallographic orientations. For instance, (110) silicon is compositionally distinct or different from (100) silicon. Creating a stack of different orientations could be accomplished, for instance, with blanket wafer layer transfer. If two materials are elementally different, then one of the materials has an element that is not in the other material.

### Architecture

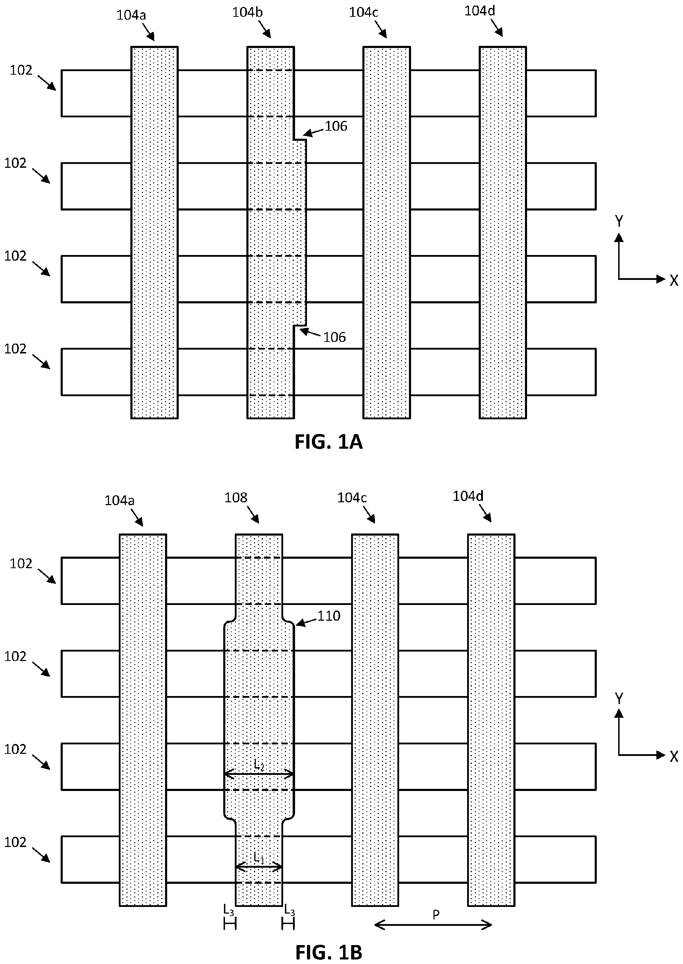

Figure 1A is a plan view taken across a plurality of semiconductor fins 102 extending along a first direction and a plurality of gate lines 104a - 104d extending along a second direction and over the plurality of semiconductor fins 102 with one gate line 104b exhibiting a change in its gate length. Figure 1B is a plan view taken across a plurality of semiconductor fins 102 extending along the first direction and a plurality of gate lines extending along a second direction and over the plurality of semiconductor fins 102 with one gate line 108 exhibiting a different change in its gate length. according to an embodiment of the present disclosure.

The various semiconductor fins 102 may be formed from a semiconductor substrate. Any number of parallel semiconductor fins 102 can be formed on or over the substrate, but four are used here as an example. The substrate can be, for example, a bulk substrate including group IV semiconductor material (such as silicon, germanium, or silicon germanium), group III-V semiconductor material (such as gallium arsenide, indium gallium arsenide, or indium phosphide), and/or any other suitable material upon which transistors can be formed. Alternatively, the substrate can be a semiconductor-on-insulator substrate having a desired semiconductor layer over a buried insulator layer (e.g., silicon over silicon dioxide). Alternatively, the substrate can be a multilayer substrate or superlattice suitable for forming nanowires or nanoribbons (e.g., alternating layers of silicon and SiGe, or alternating layers indium gallium arsenide and indium phosphide). Any number of substrate configurations can be used.

Each of the semiconductor fins 102 include semiconductor regions in the shape of fins that can be, for example, native to the substrate (formed from the substrate itself), such as silicon fins etched from a bulk silicon substrate. Alternatively, the fins can be formed of material deposited onto an underlying substrate. In one such example case, a blanket layer of silicon germanium (SiGe) can be deposited onto a silicon substrate, and then patterned and etched to form a plurality of SiGe fins extending from that substrate. In another such example, non-native fins can be formed in a so-called aspect ratio trapping based process, where native fins are etched away so as to leave fin-shaped trenches which can then be filled with an alternative semiconductor material (e.g., group IV or III-V material). In still other embodiments, the fins include alternating layers of material (e.g., alternating layers of silicon and SiGe) that facilitates forming of nanoribbons, nanosheets, or nanowires during a gate forming process where one type of the alternating layers are selectively etched away so as to liberate the other type of alternating layers within the channel region, so that a gate-all-around (GAA) process can then be carried out. Again, the alternating layers can be blanket deposited and then etched into fins or deposited into fin-shaped trenches.

Gate lines 104a - 104d represent sacrificial gate layers that are formed over semiconductor fins 102 to define the locations for the transistor gate structures. Accordingly, the patterned shape of each gate line 104a - 104d represents the final shape of the corresponding gate structures. As shown in Figure 1A, a given gate line 104b may have its gate length increased over one or more of semiconductor fins 102. The gate length may increase from a first gate length to a larger second gate length at transition regions 106. Due to the multi-step fabrication process used to form gate line 104b, the change in gate length occurs along only one side of the gate. Additionally, the fabrication process results in an abrupt step-like change at transition regions 106 as the gate length transitions between the first gate length and the second gate length. The process required to make the structure shown in Figure 1A requires multiple masking steps and etching operations making it both time consuming and costly.

Figure 1B illustrates another plan view of a series of gate lines that includes gate line 108 having a variation in its gate length, according to an embodiment of the present disclosure. The illustrated gate line 108 may be directly patterned using a single mask and EUV lithography. The resulting gate line 108 transitions between a first gate length L₁ and a second gate length L₂ greater than the first gate length. According to some embodiments, the second gate length L₂ is at least 0.5 nm greater than the first gate length L₁ (such as between 0.5 nm and 4 nm greater). According to some embodiments, the change in gate length occurs along both sides of gate line 108 and may occur equally on both sides, such that one side extends by a length L₃ between about 0.25 nm and about 2 nm and the other side also extends by the length L₃ between about 0.25 nm and about 2 nm. Gate line 108 includes transition regions 110 where the length changes between the first gate length L₁ and the second gate length L₂. According to some embodiments, these transition regions 110 are located between adjacent semiconductor fins 102 along the second direction. Unlike the example shown in Figure 1A, transition regions 110 may be more gradual, such that they are sloped or tapered rather than abrupt.

According to some embodiments, the EUV patterning process allows for patterning gate lines like those shown in Figure 1B at very small dimensions. Accordingly, a gate pitch P between adjacent gate lines may remain substantially constant across the array of gate lines (including gate line 108) and may be relatively small, such as the example case where gate pitch is less than about 80 nm. In some such cases, the gate pitch is less than about 51 nm. Other gate pitches may be used as well. According to some embodiments, the first gate length L₁ is between about 12 nm and about 20 nm and the second gate length L₂ is between about 12.5 nm and about 24 nm.

### Fabrication Methodology

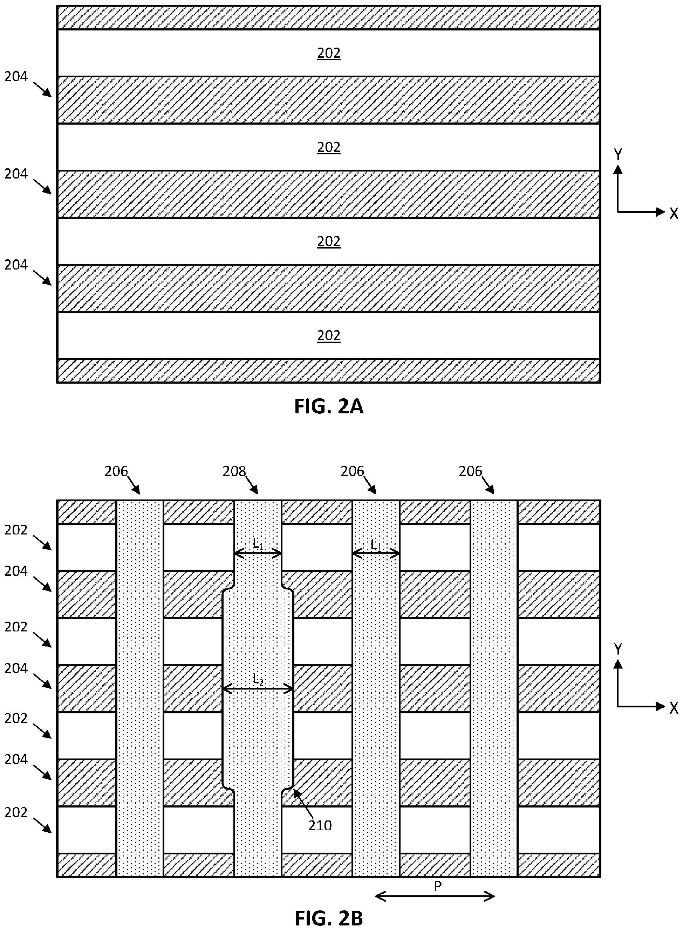

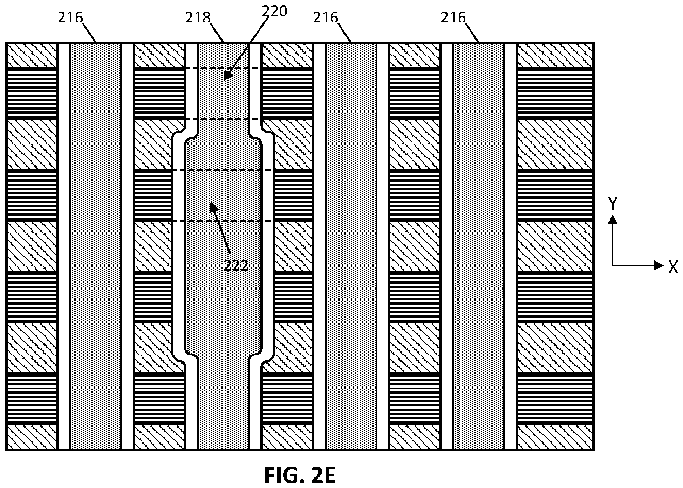

Figures 2A - 2E are plan views that collectively illustrate an example process for forming an integrated circuit configured with semiconductor devices with one or more gate structures having a varying gate length, in accordance with an embodiment of the present disclosure. Each figure shows an example structure that results from the process flow up to that point in time, so the depicted structure evolves as the process flow continues, culminating in the structure shown in Figure 2E. Such a structure may be part of an overall integrated circuit (e.g., such as a processor or memory chip) that includes, for example, digital logic cells and/or memory cells and analog mixed signal circuitry. Thus, the illustrated integrated circuit structure may be part of a larger integrated circuit that includes other integrated circuitry not depicted. Example materials and process parameters are given, but the present disclosure is not intended to be limited to any specific such materials or parameters, as will be appreciated.

Figure 2A illustrates a plan view showing a series of semiconductor fins 202 extending along a first direction (e.g., along the X-axis) and extending up from a substrate (e.g., out of the page) along with a dielectric fill 204 around a base portion of each of semiconductor fins 202, according to some embodiments. The fins may include a single semiconductor material (e.g., silicon or silicon germanium), or may include alternating material layers, such as sacrificial layers alternating with semiconductor layers. The alternating layers may be used to form GAA transistor structures, in some embodiments. According to some embodiments, the total height of semiconductor fins 202 may be between 50 nm and 150 nm, and the width of the fins (along the Y-axis) can be, for example, in the range of 5 to 50 nm.

According to some embodiments, dielectric fill 204 may act as shallow trench isolation (STI) structures between semiconductor fins 202. Dielectric fill 204 may be any suitable dielectric material, such as silicon oxide. Semiconductor fins 202 extend above a top surface of dielectric fill 204, according to some embodiments.

Figure 2B depicts the plan view of the structure shown in Figure 2A following the formation of sacrificial gate lines 206/208, according to some embodiments. Sacrificial gate lines 206/208 may be patterned in rows over semiconductor fins 202 and run in a second direction (along the Y-axis) orthogonal to a length of semiconductor fins 202. Sacrificial gate lines 206/208 may include any material that can be safely removed later in the process without etching or otherwise damaging surrounding transistor structures. According to some embodiments, sacrificial gate lines 206/208 are patterned using an EUV lithography process that utilizes a single mask to produce the resulting sacrificial gate line patterns.

According to some embodiments, sacrificial gate lines 206/208 are patterned in rows with a constant pitch P that is less than 80 nm or less than 60. In some example cases, the pitch P is less than 51 nm. Sacrificial gate lines 206 have a constant first gate length L₁, while one or more other sacrificial gate lines 208 have a gate length that changes between the first gate length L₁ and a second gate length L₂. According to some embodiments, the second gate length L₂ is at least 0.5 nm greater than the first gate length L₁ (such as between 0.5 nm and 4 nm greater,).

According to some embodiments, the change in gate length along sacrificial gate line 208 is symmetrical, in that it occurs along both sides of sacrificial gate line 208 and may occur equally on both sides. For example, one side of sacrificial gate line 208 extends outward by between about 0.25 nm and about 2 nm and the other side also extends outward by between about 0.25 nm and about 2 nm. Sacrificial gate line 208 includes transition regions 210 where the length changes between the first gate length L₁ and the second gate length L₂. According to some embodiments, these transition regions 210 are located between adjacent semiconductor fins 202 along the second direction and/or above dielectric fill 204. Transition regions 210 may be more gradual (e.g., a sloped or tapered) compared to a more abrupt step transition due to the direct lithography process made possible with EUV lithography.

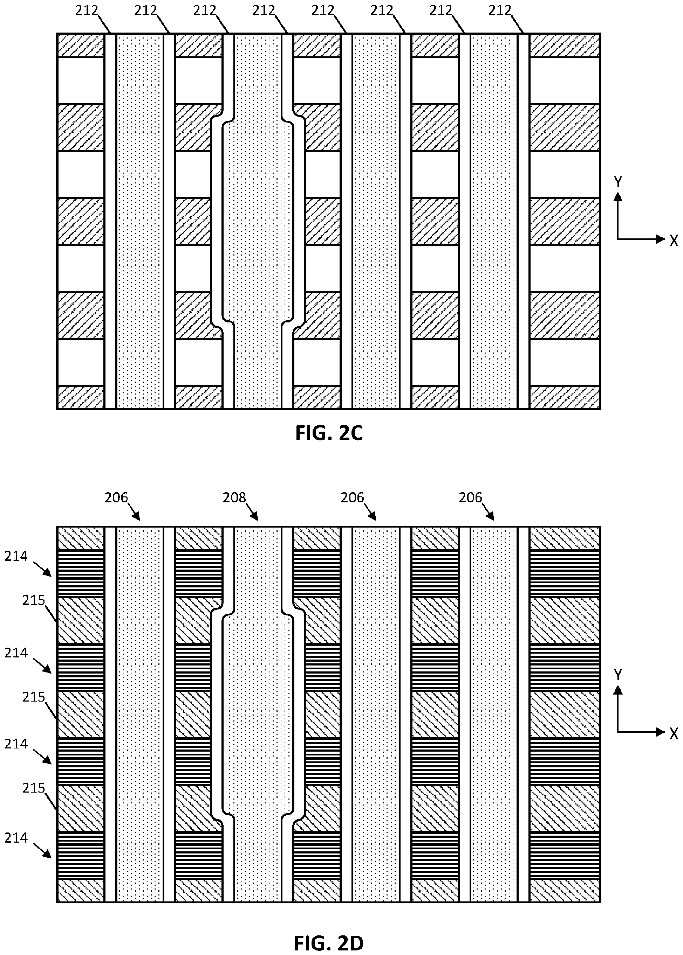

Figure 2C depicts the plan view of the structure shown in Figure 2B following the formation of spacer structures 212 along the sidewalls of sacrificial gate lines 206/208, according to some embodiments. A dielectric material may be blanked deposited across the entire structure and etched back using an anisotropic etching process (such as reactive ion etching) to leave the material on the sidewalls of structures as spacer structures 212. Spacer structures 212 can include any suitable dielectric material, such as silicon nitride. Some portion of spacer structures 212 may also develop on the sidewalls of semiconductor fins 202, according to some embodiments.

Figure 2D depicts the plan view of the structure shown in Figure 2C following the removal of the exposed fin portions not under sacrificial gate lines 206/208 and spacer structures 212. According to some embodiments, all semiconductor material of the exposed fins is etched at substantially the same rate using an anisotropic RIE process. As observed in Figure 2D, the width of spacer structures 212 along the first direction works to define the width of each of the diffusion regions etched between adjacent devices. In some embodiments, the exposed fin portions are completely removed thus exposing the underlying substrate.

According to some embodiments, source or drain regions 214 are formed between the exposed ends of the semiconductor fins beneath sacrificial gate lines 206/208 and spacer structures 212. Source or drain regions 214 may be epitaxially grown from the exposed ends of the semiconductor fins, such that the material grows together or otherwise merges towards the middle of the trench between the fins, according to some embodiments. In other embodiments, the epitaxial growth may only partially merge, or not merge at all thereby leaving space between the laterally adjacent epi-growths in which contact material can be deposited. The degree of any such merging can vary from one embodiment to the next. In the example of PMOS devices, source or drain regions 214 may be a semiconductor material (e.g., group IV or group III-V semiconductor materials) having a higher dopant concentration of p-type dopants compared to n-type dopants. In the example of NMOS devices, source or drain regions 214 may be a semiconductor material (e.g., group IV or group III-V semiconductor materials) having a higher dopant concentration of n-type dopants compared to p-type dopants. In still other embodiments, source or drain regions 214 may be implantation-doped portions of the fin structure (which can be left in place rather than removed as shown in Figure 2D).

According to some embodiments, a second dielectric fill 215 may be formed adjacent to source or drain regions 214 within the source/drain trenches. Second dielectric fill 215 may also cover the top surfaces of source or drain regions 214 within the source/drain trenches. Second dielectric fill 215 may be any suitable dielectric material, such as silicon dioxide, silicon nitride, or silicon oxynitride.

Figure 2E depicts the plan view of the structure shown in Figure 2D following the removal of sacrificial gate lines 206/208 and the subsequent formation of gate structures 216/218, according to some embodiments. Sacrificial gate lines 206/208 may be removed using any wet or dry isotropic process thus exposing the semiconductor fins - (or the thin silicon oxide coating the fin) - within the trenches left behind after the removal of sacrificial gate lines 206/208. In the case of GAA transistors, sacrificial layers within the fin structure may also be removed using a selective isotropic etching process that removes the material of the sacrificial layers but does not remove (or removes very little of) the alternating semiconductor layers. At this point, the suspended (sometimes called released) semiconductor layers form nanoribbons (or nanowires or nanosheets) that extend between source or drain regions 214. Sacrificial gate lines 206/208 and the sacrificial layers of the fin may be removed using the same isotropic etching process or different isotropic etching processes.

As noted above, gate structures 216/218 include a gate dielectric and a gate electrode. The gate dielectric may be conformally deposited around the semiconductor regions extending between source or drain regions 214 using any suitable deposition process, such as atomic layer deposition (ALD). The gate dielectric may include any suitable dielectric (such as silicon dioxide, and/or a high-k dielectric material). Examples of high-k dielectric materials include, for instance, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate, to provide some examples. According to some embodiments, the gate dielectric is hafnium oxide or a zirconium-doped hafnium oxide with a thickness between about 0.8 nm and about 5 nm. In some embodiments, the gate dielectric may include one or more silicates (e.g., titanium silicate, tungsten silicate, niobium silicate, and silicates of other transition metals). The gate dielectric may be a multilayer structure, in some examples. For instance, the gate dielectric may include a first layer on the semiconductor regions, and a second layer on the first layer. The first layer can be, for instance, an oxide of the semiconductor regions (e.g., silicon dioxide) and the second layer can be a high-k dielectric material (e.g., hafnium oxide).

The gate electrode may be deposited over the gate dielectric and can be any standard or proprietary gate structure that may include any number of gate cuts. In some embodiments, the gate electrode includes doped polysilicon, a metal, or a metal alloy. Example suitable metals or metal alloys include aluminum, tungsten, cobalt, molybdenum, ruthenium, titanium, tantalum, copper, and carbides and nitrides thereof. The gate electrode may include, for instance, one or more workfunction layers, resistance-reducing layers, and/or barrier layers. The workfunction layers can include, for example, p-type workfunction materials (e.g., titanium nitride) for PMOS gates, or n-type workfunction materials (e.g., titanium aluminum carbide) for NMOS gates.

According to some embodiments, different semiconductor devices along gate structure 218 have different gate lengths. In the illustrated example, a first semiconductor region 220 of a first semiconductor device has a first gate length and a second semiconductor region 222 of a second semiconductor device has a second gate length that is greater than the first gate length. Since sacrificial gate line 208 is replaced with gate structure 218, the dimensions and shape of gate structure 218 match that of sacrificial gate line 208. As shown, the constant pitch P is maintained, and the gate line 208 is symmetrical along its length (up and down the page). The sloped or tapered transition from one gate length to the other is also maintained. Also, the transition from the first gate length to the second gate length occurs completely within a region between the semiconductor fins 202 along the second direction. In this example case, the transition region corresponds to the isolation region provided by dielectric fill 215.

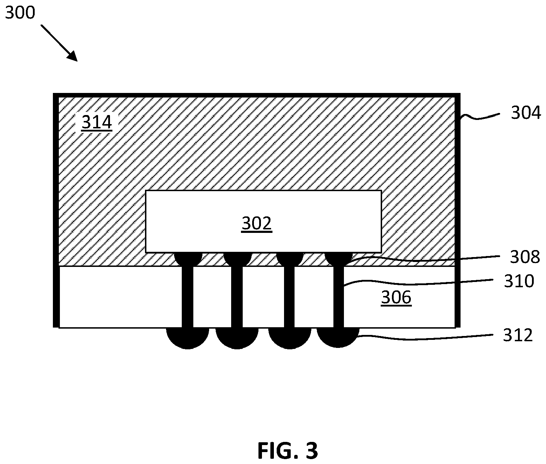

Figure 3 illustrates an example embodiment of a chip package 300. As can be seen, chip package 300 includes one or more dies 302. One or more dies 302 may include at least one integrated circuit having semiconductor devices, such as any of the semiconductor devices disclosed herein. One or more dies 302 may include any other circuitry used to interface with other devices formed on the dies, or other devices connected to chip package 300, in some example configurations.

As can be further seen, chip package 300 includes a housing 304 that is bonded to a package substrate 306. The housing 304 may be any standard or proprietary housing, and provides, for example, electromagnetic shielding and environmental protection for the components of chip package 300. The one or more dies 302 may be conductively coupled to a package substrate 306 using connections 308, which may be implemented with any number of standard or proprietary connection mechanisms, such as solder bumps, ball grid array (BGA), pins, or wire bonds, to name a few examples. Package substrate 306 may be any standard or proprietary package substrate, but in some cases includes a dielectric material having conductive pathways (e.g., including conductive vias and lines) extending through the dielectric material between the faces of package substrate 306, or between different locations on each face. In some embodiments, package substrate 306 may have a thickness less than 1 millimeter (e.g., between 0.1 millimeters and 0.5 millimeters), although any number of package geometries can be used. Additional conductive contacts 312 may be disposed at an opposite face of package substrate 306 for conductively contacting, for instance, a printed circuit board (PCB). One or more vias 310 extend through a thickness of package substrate 306 to provide conductive pathways between one or more of connections 308 to one or more of contacts 312. Vias 310 are illustrated as single straight columns through package substrate 306 for ease of illustration, although other configurations can be used (e.g., damascene, dual damascene, through-silicon via). In still other embodiments, vias 310 are fabricated by multiple smaller stacked vias, or are staggered at different locations across package substrate 306. In the illustrated embodiment, contacts 312 are solder balls (e.g., for bump-based connections or a ball grid array arrangement), but any suitable package bonding mechanism may be used (e.g., pins in a pin grid array arrangement or lands in a land grid array arrangement). In some embodiments, a solder resist is disposed between contacts 312, to inhibit shorting.

In some embodiments, a mold material 314 may be disposed around the one or more dies 302 included within housing 304 (e.g., between dies 302 and package substrate 306 as an underfill material, as well as between dies 302 and housing 304 as an overfill material). Although the dimensions and qualities of the mold material 314 can vary from one embodiment to the next, in some embodiments, a thickness of mold material 314 is less than 1 millimeter. Example materials that may be used for mold material 314 include epoxy mold materials, as suitable. In some cases, the mold material 314 is thermally conductive, in addition to being electrically insulating.

### Methodology

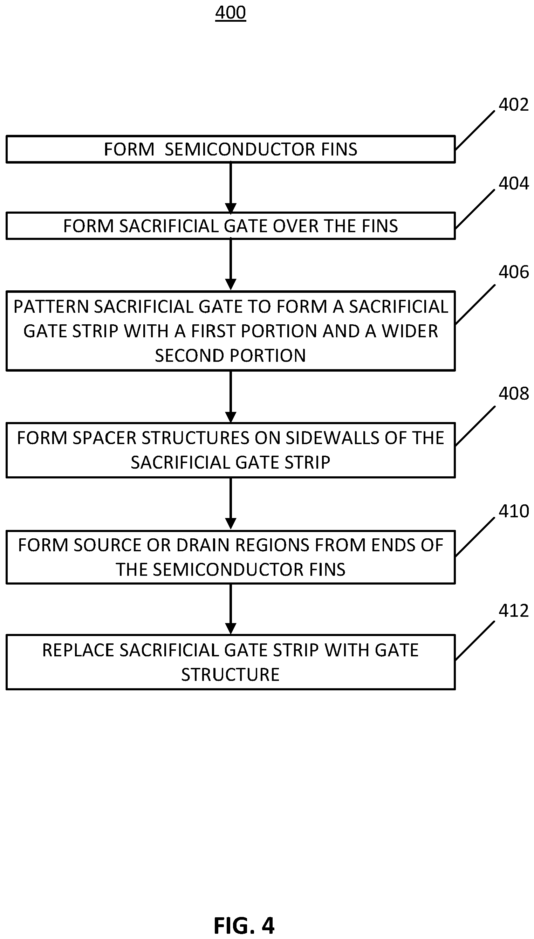

Figure 4 is a flow chart of a method 400 for forming at least a portion of an integrated circuit, according to an embodiment. Various operations of method 400 may be illustrated in Figures 2A - 2E. However, the correlation of the various operations of method 400 to the specific components illustrated in the aforementioned figures is not intended to imply any structural and/or use limitations. Rather, the aforementioned figures provide one example embodiment of method 400. Other operations may be performed before, during, or after any of the operations of method 400. Some of the operations of method 400 may be performed in a different order than the illustrated order.

Method 400 begins with operation 402 where at least first and second semiconductor fins are formed, according to some embodiments. The fins may extend parallel to one another along a first direction. The semiconductor material in the fins may be formed from a substrate such that the fins are an integral part of the substrate (e.g., etched from a bulk silicon substrate). Alternatively, the fins can be formed of material deposited onto an underlying substrate. In one such example case, a blanket layer of silicon germanium (SiGe) can be deposited onto a silicon substrate, and then patterned and etched to form a plurality of SiGe fins extending from that substrate. In another such example, non-native fins can be formed in a so-called aspect ratio trapping based process, where native fins are etched away so as to leave fin-shaped trenches which can then be filled with an alternative semiconductor material (e.g., group IV or III-V material). In still other embodiments, the fins include alternating layers of material (e.g., alternating layers of silicon and SiGe) that facilitates forming of nanowires and nanoribbons during a gate forming process where one type of the alternating layers are selectively etched away so as to liberate the other type of alternating layers within the channel region, so that a gate-all-around process can then be carried out. Again, the alternating layers can be blanket deposited and then etched into fins or deposited into fin-shaped trenches.

Method 400 continues with operation 404 where a sacrificial gate material is formed over the fins. The sacrificial gate material may include any material that can be safely removed later in the process without etching or otherwise damaging surrounding transistor structures. The sacrificial gate material may include polysilicon.

Method 400 continues with operation 406 where the sacrificial gate material is patterned to form a sacrificial gate strip extending over multiple fins along a second direction substantially orthogonal to the first direction. According to some embodiments, an EUV lithography process is performed to pattern the sacrificial gate strip with a first gate portion having a first gate length (e.g., dimension along the first direction) and with a second gate portion having a second gate length greater than the first gate length. According to some embodiments, the second gate portion extends beyond both sides of the first gate portion along the first direction and the second gate length is at least 0.5 nm greater than the first gate length. The second gate portion may extend equally on both sides of the first gate portion, such that the second gate portion extends at least 0.5 nm, at least 1 nm, or at least 2 nm beyond each side of the first gate portion.

According to some embodiments, the sacrificial gate strip is one of a plurality of parallel sacrificial gate strips having a pitch of less than 80 nm or less than 36 nm. Due to the direct patterning of the shape of the sacrificial gate strip using EUV lithography, the transition between the first gate portion and the second gate portion may be gradual (e.g., a sloped or tapered) as opposed to a more abrupt step transition between the different gate lengths.

Method 400 continues with operation 408 where spacer structures are formed on sidewalls of the sacrificial gate strip. The spacer structures may include silicon nitride. The spacer structures are formed on sidewalls of the sacrificial gate strip and etched back to remove the spacer structure material from any horizontal surfaces.

Method 400 continues with operation 410 where source or drain regions are formed at the ends of the semiconductor regions of each of the fins. Any portions of the fins not protected by the sacrificial gate strip and spacer structures may be removed using, for example, an anisotropic etching process followed by the epitaxial growth of the source or drain regions from the exposed ends of the semiconductor layers in the fins. In some example embodiments, the source or drain regions are NMOS source or drain regions (e.g., epitaxial silicon) or PMOS source or drain regions (e.g., epitaxial SiGe). Another dielectric fill may be formed adjacent to the various source or drain regions for additional electrical isolation between adjacent regions. The dielectric fill may also extend over a top surface of the source or drain regions. In some embodiments, topside conductive contacts may be formed through the dielectric fill to contact one or more of the source or drain regions.

Method 400 continues with operation 412 where the sacrificial gate strip is removed and replaced with a gate structure. The sacrificial gate strip may be removed using an isotropic etching process that selectively removes all of the material from the sacrificial gate strip, thus exposing the various fins between the set of spacer structures. In the example case where GAA transistors are used, any sacrificial layers within the exposed fins between the spacer structures may also be removed to release nanoribbons, nanosheets, or nanowires of semiconductor material.

The gate structure may include both a gate dielectric and a gate electrode. The gate dielectric is first formed over the exposed semiconductor regions between the spacer structures followed by forming the gate electrode within the remainder of the trench b etween the spacer structures, according to some embodiments. The gate dielectric may include any number of dielectric layers deposited using a CVD process, such as ALD. The gate electrode can include any number of conductive material layers, such as any metals, metal alloys, or polysilicon. The gate electrode may be deposited using electroplating, electroless plating, CVD, ALD, PECVD, or PVD, to name a few examples. In some embodiments, the gate electrode may be recessed, and a dielectric gate cap is formed within the recessed area.

Since the gate structure has the same shape and dimensions as the sacrificial gate strip, the gate structure has the first gate portion with the first gate length over one or more first semiconductor regions and the second gate portion with the second gate length over one or more second semiconductor regions.

### Example System

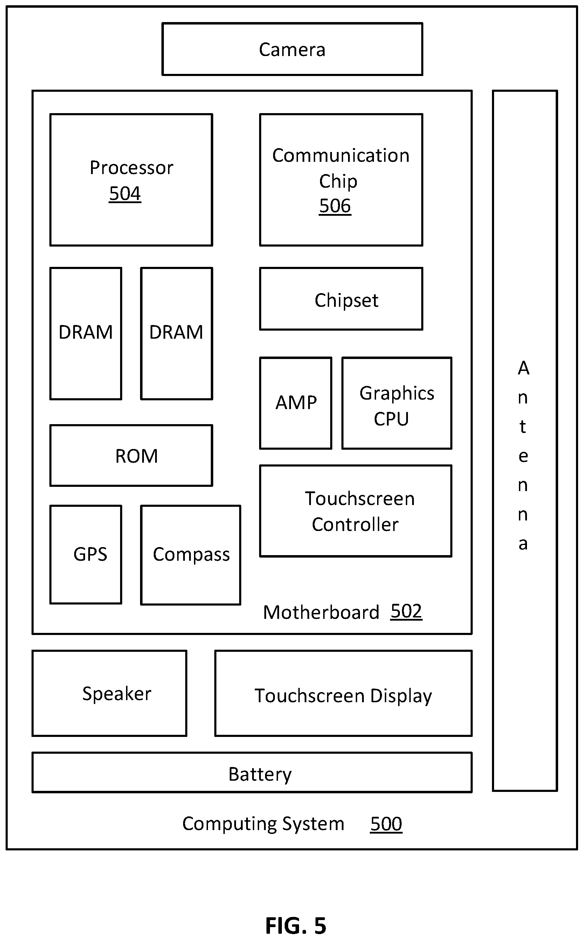

Figure 5 is an example computing system implemented with one or more of the integrated circuit structures as disclosed herein, in accordance with some embodiments of the present disclosure. As can be seen, the computing system 500 houses a motherboard 502. The motherboard 502 may include a number of components, including, but not limited to, a processor 504 and at least one communication chip 506, each of which can be physically and electrically coupled to the motherboard 502, or otherwise integrated therein. As will be appreciated, the motherboard 502 may be, for example, any printed circuit board (PCB), whether a main board, a daughterboard mounted on a main board, or the only board of system 500, etc.

Depending on its applications, computing system 500 may include one or more other components that may or may not be physically and electrically coupled to the motherboard 502. These other components may include, but are not limited to, volatile memory (e.g., DRAM), non-volatile memory (e.g., ROM), a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth). Any of the components included in computing system 500 may include one or more integrated circuit structures or devices configured in accordance with an example embodiment (e.g., a module including an integrated circuit device on a substrate, the substrate having one or more semiconductor devices with different gate lengths, as variously provided herein). In some embodiments, multiple functions can be integrated into one or more chips (e.g., for instance, note that the communication chip 506 can be part of or otherwise integrated into the processor 504).

The communication chip 506 enables wireless communications for the transfer of data to and from the computing system 500. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 506 may implement any of a number of wireless standards or protocols, including, but not limited to, Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing system 500 may include a plurality of communication chips 506. For instance, a first communication chip 506 may be dedicated to shorter range wireless communications such as Wi-Fi and Bluetooth and a second communication chip 506 may be dedicated to longer range wireless communications such as GPS, EDGE, GPRS, CDMA, WiMAX, LTE, Ev-DO, and others.

The processor 504 of the computing system 500 includes an integrated circuit die packaged within the processor 504. In some embodiments, the integrated circuit die of the processor includes onboard circuitry that is implemented with one or more semiconductor devices as variously described herein. The term "processor" may refer to any device or portion of a device that processes, for instance, electronic data from registers and/or memory to transform that electronic data into other electronic data that may be stored in registers and/or memory.

The communication chip 506 also may include an integrated circuit die packaged within the communication chip 506. In accordance with some such example embodiments, the integrated circuit die of the communication chip includes one or more semiconductor devices as variously described herein. As will be appreciated in light of this disclosure, note that multi-standard wireless capability may be integrated directly into the processor 504 (e.g., where functionality of any chips 506 is integrated into processor 504, rather than having separate communication chips). Further note that processor 504 may be a chip set having such wireless capability. In short, any number of processor 504 and/or communication chips 506 can be used. Likewise, any one chip or chip set can have multiple functions integrated therein.

In various implementations, the computing system 500 may be a laptop, a netbook, a notebook, a smartphone, a tablet, a personal digital assistant (PDA), an ultra-mobile PC, a mobile phone, a desktop computer, a server, a printer, a scanner, a monitor, a set-top box, an entertainment control unit, a digital camera, a portable music player, a digital video recorder, or any other electronic device that processes data or employs one or more integrated circuit structures or devices formed using the disclosed techniques, as variously described herein.

It will be appreciated that in some embodiments, the various components of the computing system 500 may be combined or integrated in a system-on-a-chip (SoC) architecture. In some embodiments, the components may be hardware components, firmware components, software components or any suitable combination of hardware, firmware or software.

### Further Example Embodiments

The following examples pertain to further embodiments, from which numerous permutations and configurations will be apparent.

Example 1 is an integrated circuit that includes a first semiconductor region extending from a first source or drain region along a first direction, a second semiconductor region extending from a second source or drain region along the first direction, and a gate structure extending over the first semiconductor region and the second semiconductor region along a second direction different from the first direction. The gate structure has a first gate portion with a first gate length along the first direction over the first semiconductor region and a second gate portion with a second gate length along the first direction over the second semiconductor region. The second gate length is between 0.5-5 nm greater than the first gate length. The second gate portion extends beyond both sides of the first gate portion along the first direction.

Example 2 includes the integrated circuit of Example 1, wherein the first semiconductor region comprises a first plurality of semiconductor nanoribbons and the second semiconductor region comprises a second plurality of semiconductor nanoribbons.

Example 3 includes the integrated circuit of Example 2, wherein the first plurality of semiconductor nanoribbons and the second plurality of semiconductor nanoribbons comprise silicon, germanium, or a combination of both.

Example 4 includes the integrated circuit of any one of Examples 1-3, wherein the first gate length is between 12 nm and 20 nm.

Example 5 includes the integrated circuit of any one of Examples 1-4, wherein the second gate length is between 0.5-4 nm greater than the first gate length.

Example 6 includes the integrated circuit of any one of Examples 1-4, wherein the second gate length is between 0.5-3 nm greater than the first gate length.

Example 7 includes the integrated circuit of any one of Examples 1-4, wherein the second gate length is between 0.5-2 nm greater than the first gate length.

Example 8 includes the integrated circuit of any one of Examples 1-7, wherein the gate structure is a first gate structure and the integrated circuit further comprises a second gate structure extending along the second direction parallel to the first gate structure, wherein a pitch between the first gate structure and the second gate structure along the first direction is less than 80 nm.

Example 9 includes the integrated circuit of Example 8, wherein the pitch between the first gate structure and the second gate structure along the first direction is less than 51 nm.

Example 10 includes the integrated circuit of any one of Examples 1-9, wherein a transition between the first gate portion and the second gate portion is located between the first semiconductor region and the second semiconductor region along the second direction.

Example 11 is a printed circuit board that includes the integrated circuit of any one of Examples 1-10.

Example 12 is an electronic device that includes a chip package having one or more dies. At least one of the one or more dies includes a first semiconductor region extending from a first source or drain region along a first direction, a second semiconductor device having a second semiconductor region extending from a second source or drain region along the first direction, and a gate structure extending over the first semiconductor region and the second semiconductor region along a second direction different from the first direction. The gate structure has a first gate portion with a first gate length along the first direction over the first semiconductor region and a second gate portion with a second gate length along the first direction over the second semiconductor region. The second gate length is between 0.5-4 nm greater than the first gate length. The second gate portion extends beyond both sides of the first gate portion along the first direction.

Example 13 includes the electronic device of Example 12, wherein the first semiconductor region comprises a first plurality of semiconductor nanoribbons and the second semiconductor region comprises a second plurality of semiconductor nanoribbons.

Example 14 includes the electronic device of Example 13, wherein the first plurality of semiconductor nanoribbons and the second plurality of semiconductor nanoribbons comprise silicon, germanium, or a combination of both.

Example 15 includes the electronic device of any one of Examples 12-14, wherein the first gate length is between about 12 nm and about 20 nm, and the second gate length is between 0.5-2 nm greater than the first gate length.

Example 16 includes the electronic device of any one of Examples 12-15, wherein the gate structure is a first gate structure and the at least one of the one or more dies further comprises a second gate structure extending along the second direction parallel to the first gate structure, wherein a pitch between the first gate structure and the second gate structure along the first direction is less than 80 nm.

Example 17 includes the electronic device of Example 16, wherein the pitch between the first gate structure and the second gate structure along the first direction is less than 51 nm.

Example 18 includes the electronic device of any one of Examples 12-17, wherein a transition between the first gate portion and the second gate portion is located between the first semiconductor region and the second semiconductor region along the second direction.

Example 19 includes the electronic device of any one of Examples 12-18, further comprising a printed circuit board, wherein the chip package is attached to the printed circuit board.

Example 20 is a method of forming an integrated circuit. The method includes forming a first fin and a second fin comprising semiconductor material, the first and second fins extending above a substrate and extending parallel to each other in a first direction; forming sacrificial gate material over the first fin and the second fin; forming a dielectric cap material over the sacrificial gate material; patterning the sacrificial gate material and dielectric cap material to form a sacrificial gate strip extending in a second direction over the first fin and the second fin, wherein the sacrificial gate strip has a first portion with a first length along the first direction over the first fin and a second portion with a second length along the first direction over the second fin, the second length being between 0.5-5 nm greater than the first length, and wherein the second portion extends beyond both sides of the first portion along the first direction; forming spacer structures on sidewalls of the sacrificial gate strip; forming source or drain regions at ends of the first fin and second fin; and replacing the sacrificial gate strip with a gate structure.

Example 21 includes the method of Example 20, wherein patterning the sacrificial gate material and dielectric cap material comprises patterning using extreme ultraviolet (EUV) lithography.

Example 22 includes the method of Example 20 or 21, wherein the first length is between about 12 nm and about 20 nm.

Example 23 includes the method of any one of Examples 20-22, wherein the second gate length is between 0.5-4 nm greater than the first gate length.

Example 24 includes the method of any one of Examples 20-22, wherein the second gate length is between 0.5-3 nm greater than the first gate length.

Example 25 includes the method of any one of Examples 20-22, wherein the second gate length is between 0.5-2 nm greater than the first gate length.

Example 26 includes the method of any one of Examples 20-25, wherein the sacrificial gate strip is a first sacrificial gate strip and the method further includes forming a second sacrificial gate strip extending along the second direction parallel to the first sacrificial gate strip, wherein a pitch between the first sacrificial gate strip and the second sacrificial gate strip along the first direction is less than 80 nm.

Example 27 includes the method of Example 26, wherein the pitch between the first sacrificial gate strip and the second sacrificial gate strip along the first direction is less than 51 nm.

Example 28 includes the method of any one of Examples 20-27, wherein the first portion and the second portion are both formed at the same time.

Example 29 includes the integrated circuit of any one of Examples 1-10, the printed circuit board of Example 11, or the electronic device of any one of Examples 12-19, wherein a transition between the first gate length and the second gate length occurs completely within a region between the first and second semiconductor regions along the second direction.

Example 30 includes the method of any one of Examples 20-28, wherein a transition between the first gate length and the second gate length occurs completely within a region between the first and second fins along the second direction.

The foregoing description of the embodiments of the disclosure has been presented for the purposes of illustration and description. It is not intended to be exhaustive or to limit the disclosure to the precise forms disclosed. Many modifications and variations are possible in light of this disclosure. It is intended that the scope of the disclosure be limited not by this detailed description, but rather by the claims appended hereto.

## Claims

1. An integrated circuit, comprising:
a first semiconductor region extending from a first source or drain region along a first direction;
a second semiconductor region extending from a second source or drain region along the first direction; and
a gate structure extending over the first semiconductor region and the second semiconductor region along a second direction different from the first direction,
wherein the gate structure has a first gate portion with a first gate length along the first direction over the first semiconductor region and a second gate portion with a second gate length along the first direction over the second semiconductor region, the second gate length being between 0.5-5 nm greater than the first gate length,
wherein the second gate portion extends beyond both sides of the first gate portion along the first direction.

2. The integrated circuit of claim 1, wherein the first semiconductor region comprises a first plurality of semiconductor nanoribbons and the second semiconductor region comprises a second plurality of semiconductor nanoribbons.

3. The integrated circuit of Example 2, wherein the first plurality of semiconductor nanoribbons and the second plurality of semiconductor nanoribbons comprise silicon, germanium, or a combination of both.

4. The integrated circuit of claim 1, wherein the first gate length is between 12 nm and 20 nm.

5. The integrated circuit of any one of claims 1 through 4, wherein the second gate length is between 0.5-4 nm greater than the first gate length.

6. The integrated circuit of any one of claims 1 through 4, wherein the second gate length is between 0.5-3 nm greater than the first gate length.

7. The integrated circuit of any one of claims 1 through 4, wherein the second gate length is between 0.5-2 nm greater than the first gate length.

8. The integrated circuit of any one of claims 1 through 7, wherein the gate structure is a first gate structure and the integrated circuit further comprises a second gate structure extending along the second direction parallel to the first gate structure, wherein a pitch between the first gate structure and the second gate structure along the first direction is less than 80 nm.

9. The integrated circuit of claim 8, wherein the pitch between the first gate structure and the second gate structure along the first direction is less than 51 nm.

10. The integrated circuit of any one of claims 1 through 9, wherein a transition between the first gate portion and the second gate portion is located between the first semiconductor region and the second semiconductor region along the second direction.

11. The integrated circuit of any one of claims 1 through 10, wherein a transition between the first gate length and the second gate length occurs completely within a region between the first and second semiconductor regions along the second direction.

12. A printed circuit board comprising the integrated circuit of any one of claims 1 through 11.

13. A method of forming an integrated circuit, comprising:
forming a first fin and a second fin comprising semiconductor material, the first and second fins extending above a substrate and extending parallel to each other in a first direction;
forming sacrificial gate material over the first fin and the second fin;
forming a dielectric cap material over the sacrificial gate material;
patterning the sacrificial gate material and dielectric cap material to form a sacrificial gate strip extending in a second direction over the first fin and the second fin, wherein the sacrificial gate strip has a first portion with a first length along the first direction over the first fin and a second portion with a second length along the first direction over the second fin, the second length being between 0.5-5 nm greater than the first length, and wherein the second portion extends beyond both sides of the first portion along the first direction;
forming spacer structures on sidewalls of the sacrificial gate strip;
forming source or drain regions at ends of the first fin and second fin; and
replacing the sacrificial gate strip with a gate structure.

14. The method of claim 13, wherein patterning the sacrificial gate material and dielectric cap material comprises patterning using extreme ultraviolet (EUV) lithography.

15. The method of claim 13 or 14, wherein the sacrificial gate strip is a first sacrificial gate strip and the method further includes forming a second sacrificial gate strip extending along the second direction parallel to the first sacrificial gate strip, wherein a pitch between the first sacrificial gate strip and the second sacrificial gate strip along the first direction is less than 80 nm, and wherein the pitch between the first sacrificial gate strip and the second sacrificial gate strip along the first direction is less than 51 nm, and wherein the first portion and the second portion are both formed at the same time.
